# EUROPEAN PATENT SPECIFICATION

(11) **EP 2 679 765 B1**
(45) Date of publication and mention of the grant of the patent: **06.03.2019**
(21) Application number: 12174169.8
(22) Date of filing: 28.06.2012
(51) Int. Cl.: E21B 36/00, H05K 5/06, F28D 1/02

(54) **Subsea unit comprising a two-phase cooling system**
Unterwassereinheit mit einem Zweiphasen-Kühlsystem
Unité sous-marine comprenant un système de refroidissement à deux phases

(43) Date of publication of application: 01.01.2014
(73) Proprietor: ABB Schweiz AG, 5400 Baden (CH)
(72) Inventor: Spindler, Christian, 8707 Uetikon am See (CH); Gradinger, Tomas, 5032 Aarau Rohr (CH)
(74) Representative: Savela, Reino Aleksi

(56) References cited:
- WO-A1-2008/004885
- GB-A- 2 313 181
- US-A- 5 265 677
- US-A1- 2008 302 115
- US-B1- 6 978 828

## Description

### TECHNICAL FIELD

The present disclosure generally relates to subsea installations and in particular to a subsea unit comprising a two-phase cooling system for cooling an electric or electronic device arranged in the subsea unit.

### BACKGROUND

Power semiconductors are employed as main switching elements in power electronic equipment such as frequency converters. Cooling systems are essential in power electronic devices to transfer the heat generated by the power semiconductors. Frequency converters in the medium voltage and power range drive electric motors by controlling the speed and torque of these machines and are a well proven equipment in the entire onshore and offshore platform based industry.

In recent years, there has been a growing interest in installing electrical installations on the sea floor in depths from a few tens of meters to even kilometres. Oil and gas production subsea employs electric equipment like drilling motors, pumps, and compressors that are currently driven by frequency converters located on topside platforms. Electric power is provided to the subsea machinery by expensive umbilicals. By installing frequency converters and other power electronic equipment subsea, cables and topside installations could be spared and enormous cost savings could be achieved.

In bringing power electronics subsea, two general concepts exist: (1) the equipment stays at atmospheric pressure; and (2) the equipment is pressurized to the hydrostatic pressure level on seabed. The two concepts can be differentiated as follows. Concept (1) has the advantage that standard electric/electronic components, known from onshore installations, can be used, while disadvantages include thick walls needed for the enclosure to withstand the pressure difference between inside and outside. Thick walls make the equipment heavy and costly. In addition, heat transfer through thick walls is not very efficient and huge, expensive cooling units are required. Concept (2) has the advantage that no thick walls are needed for the enclosure since no pressure difference exists between inside and outside the containment. Cooling is greatly facilitated by thin walls. Disadvantages of concept (2) are that all the components must be free of gas inclusions and compressible voids, otherwise they implode during pressurization and are destroyed.

"Controlled subsea electric power distribution with SEPDIS™" by Sølvik et al. published in ABB Review 2/2000 discloses a two-phase cooling system relating to concept (1). In particular this paper discloses a passive cooling system arranged to cool a subsea frequency converter of a very thick wall pressure vessel.

The problem of cooling power electronics in subsea equipment is however not yet solved satisfyingly. Challenges include *inter alia* reducing the size and cost of currently applied, thick-walled heat exchangers.

WO 2008/004885 discloses a lightweight underwater cooling assembly. The cooling assembly is connected to a pressure vessel and comprises a refrigerant boiling chamber in which heat exchanger tubes are provided. The cooling assembly has a thin-walled water cooled condenser and a thin-walled pressure compensating membrane which maintains the fluid pressure within the boiling chamber and condenser substantially similar to the fluid pressure of the sea water surrounding the submerged refrigerant boiling chamber. The heat exchanger tubes and the pressure vessel on the other hand are adapted to withstand the internal operational pressure as well as the external seawater pressure. The refrigerant is a suitably selected liquid that boils at ambient seawater pressure at a temperature lower than the external wall temperature of heat exchanger tubes.

US5265677 discloses a refrigerant-cooled downhole tool. The tool comprises electronic circuits that are to be cooled such that they maintain a temperature within a predetermined temperature operating range. The tool has a recycling cooling system comprising a condenser and an evaporator. The evaporator is in connection with electrical circuits for cooling thereof. The refrigerant is normally arranged in a chamber of a container at a pressure of about 50 to about 300 psi. In another chamber of the container, high pressure gas is provided. The container is further in fluid communication with the surrounding downhole fluid. When the downhole fluid pressure is greater than the pressure of the gas in chamber, a piston is moved, whereby refrigerant is discharged through a check-valve, flowing through the condenser and evaporator and back to the chamber.

GB2313191 discloses an apparatus for actively cooling instrumentation, especially in high temperature environments, in particular electronic circuits in a logging tool. The apparatus comprises a lower tank containing a cooling agent e.g. water, a heat exchanger e.g. heat pipes to transfer heat from the instrumentation to the cooling agent, a compressor and an upper tank to hold cooling agent removed from the first tank. In this operation, the cooling tank is located in close proximity to the instrumentation. As the instruments generate heat, the heat is transferred through the heat exchanger to the cooling agent. The cooling agent boils and vaporises and is pumped out of the lower tank by the compressor. As the cooling agent vaporises and is pumped out of the tank, heat contained in the cooling agent is transferred out of the tank. The rate at which the vapour is pumped out of the tank controls the temperature of the cooling agent in the tank. The vapour is compressed under pressure and pumped to a storage tank where the vapour condenses back to a liquid. Once the lower tank is emptied of cooling agent, the system is spent and the tool must return to the surface and the tank refilled. Likewise, the upper tank must be emptied before the tool re-enters the borehole.

US2008/302115 discloses a container for containing underwater sensors such as sonar transceivers, sonar imaging devices, optical imaging devices, electronic equipment and a cooling liquid for cooling the electronic equipment is connected to a second, variable volume container which acts both as a heat exchanger and as a pressure compensator for compensating the pressure difference between the cooling fluid and the surrounding water or other fluid.

### SUMMARY

In view of the above, a general object of the present disclosure is to provide a subsea unit that solves or at least mitigates the problems of the prior art. Hence, according to a first aspect of the present disclosure there is provided a subsea unit arranged to house an electric or electronic device, wherein the subsea unit comprises a two-phase cooling system arranged to cool the electric or electronic device, which two-phase cooling system has an evaporator, a condenser, and a conduit which together with the evaporator and condenser forms a closed loop for circulating a cooling fluid, wherein the evaporator is arranged to be in thermal connection with the electric or electronic device, and wherein the subsea unit has an enclosure arranged to enclose the two-phase cooling system, which enclosure has a portion that is mechanically flexible such that an ambient subsea pressure can be transmitted to the inside of the enclosure, and wherein the subsea unit comprises a liquid for counteracting deformation of the enclosure when subject to an ambient subsea pressure higher than a pressure that the enclosure can withstand.

By means of a two-phase cooling system in a pressurised subsea unit which has an enclosure having a portion that is mechanically flexible to allow ambient subsea pressure to be transmitted to the inside of the subsea unit, robust, efficient and affordable subsea cooling may be provided. When the subsea unit is submerged into water, water flowing on the outside of the enclosure may for example have a cooling effect on e.g. the condenser.

According to one embodiment the conduit has a portion that is mechanically flexible so as to allow pressure inside the enclosure and outside the conduit to be transmitted to the inside of the conduit.

According to one embodiment the two-phase cooling system comprises a cooling fluid comprising at least two components that provide a thermodynamic two-phase state of the cooling fluid at a pressure higher than the critical pressure of any of the individual components of the cooling fluid.

When a single-component two-phase cooling system is pressurised to ambient sea-water pressure, which for example may be in the range of 100 to 400 bar and above the critical pressure of the single component, there is no difference between liquid and gas any more, and hence there is no liquid-gas two-phase equilibrium any more. At pressures equal to or higher than the critical pressure, vapour-liquid cooling is not possible any more, since there is no latent heat or vaporisation anymore and no density difference between vapour and liquid that can drive the fluid motion in a passive cooling cycle. Even at pressures slightly below the critical pressure, two-phase cooling does not work efficiently, since the latent heat of vaporisation decreases strongly towards the critical pressure. No known single-component fluids have critical pressures suitable for deep sea applications. Moreover, apart from the requirement of a sufficiently high critical pressure, also the boiling temperature at the pressure of interest should be in the right range. The boiling temperature should be around 60 °C for power-electronics cooling. Hence, the boiling temperatures of those single-component fluids available for higher pressures, e.g. ammonium and water, are far too high even for pressures around 100 bar.

According to one embodiment the at least two components are adapted to provide a thermodynamic two-phase state of the cooling fluid at ambient pressure at a depth at which the subsea unit is to be installed. Advantageously, the at least two components are adapted to provide a vapour-liquid two phase state at ambient pressures at a depth at which the subsea unit is to be installed

According to one embodiment the conduit is partially filled with the cooling fluid when the conduit is subjected to sea level pressure, and wherein the subsea unit comprises a pressure compensating vessel comprising additional cooling fluid, and a valve, wherein the conduit is arranged to be in fluid connection with the pressure compensation vessel via the valve such that the additional cooling fluid is able to flow from the pressure compensating vessel to the conduit when the subsea unit is subjected to a pressure that is higher than a pressure inside the conduit. Thereby thick walls of the conduit of the two-phase cooling system may be avoided. Thick walls are costly and are detrimental to the thermal performance. In order to avoid thick walls, pressure differences across the conduit walls should be kept low. In particular, the pressure in the conduit should be continuously adapted to the outside pressure when lowering the equipment to seabed; i.e. the pressure in the conduit should successively be increased from atmospheric pressure to water pressure on the seabed.

According to one embodiment the additional cooling fluid in the pressure compensating vessel is pressurised to seabed pressure of a depth at which the subsea unit is to be installed. Hence, during the lowering of the subsea unit to seabed, the valve may open just enough to let as much additional cooling fluid pass to the conduit as is necessary to increase the conduit pressure to about ambient pressure.

According to one embodiment the valve has a body having a through opening in the axial direction of a conduit portion connected to the valve, which valve is movable in a radial direction of the conduit portion between a first position in which the body blocks the additional cooling fluid from flowing from the pressure compensating vessel to the conduit and a second position in which the through opening is aligned with the interior of the conduit portion to thereby allow the additional cooling fluid to flow from the pressure compensating vessel to the conduit. Hence, a simple passive mechanical valve construction may be provided, reducing the risk of equipment failure.

According to one embodiment the valve has a first end in fluid communication with the cooling fluid in the conduit and a second end, opposite the first end, subjected to ambient pressure, wherein a pressure difference between the first end and the second end allows the body to move between the first position and the second position.

One embodiment comprises a mechanical spring arranged to provide a force in the radial direction at the first end of the valve so as to enable the body to move from the second position to the first position.

As an alternative to the mechanical valve construction, one embodiment may comprise a first pressure sensor and a second pressure sensor arranged to measure a pressure in the conduit and outside the conduit in the subsea unit, respectively, and a control unit arranged to control the valve based on measurements of the first pressure sensor and the second pressure sensor.

One embodiment comprises a pressure-relief valve connecting the conduit and an exterior of the subsea unit, wherein the pressure-relief valve is arranged to open when the ambient pressure in the subsea unit is lower than the pressure in the conduit to thereby let a portion of the cooling fluid escape the subsea unit. Thereby the subsea unit may be raised from the seabed to atmospheric pressure for servicing, as the cooling fluid can escape to ambience via the pressure-relief valve. The pressure-relief valve may be a passive device that opens once the pressure in the conduit exceeds the ambient pressure by a certain amount, similar to a steam cooker. This way, significant overpressure in the conduit is avoided at any time. The cooling fluid may be environmentally friendly, such that the cooling fluid that has escaped will not harm the environment.

According to one embodiment the condenser is in thermal connection with an exterior of the enclosure.

According to one embodiment, the two-phase cooling system comprises a cooling liquid, and wherein the conduit, the evaporator and the condenser have walls that are thick enough to withstand a pressure difference between a sealing pressure inside the conduit, the evaporator and the condenser, which sealing pressure is a pressure at which the cooling liquid has been sealed in the two-phase cooling system, and ambient pressure at a depth at which the subsea unit is to be installed

The subsea unit may advantageously be included in a subsea power system such as a transmission system or distribution system.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise. Moreover, any step in a method need not necessarily have to be carried out in the presented order, unless explicitly stated otherwise.

### BRIEF DESCRIPTION OF THE DRAWINGS

The specific embodiments of the inventive concept will now be described, by way of example, with reference to the accompanying drawings, in which:
Fig. 1a is a side view of a first example of a subsea unit for subsea installation;
Fig. 1b is a side view of a second example of a subsea unit for subsea installation; and
Figs 2a-b depict an example of a valve for ambient pressure adaptation of the cooling system of the subsea unit in Fig. 1a when lowering the subsea unit to the seabed.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

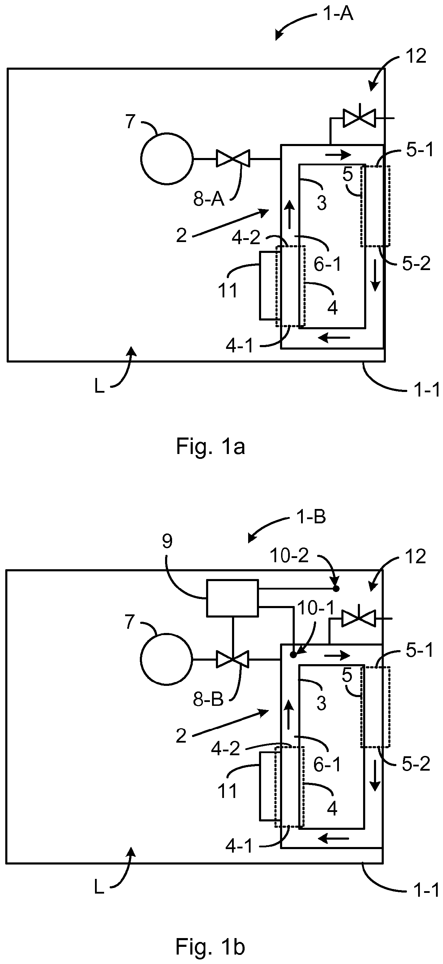

Fig. 1a depicts a side view, with the enclosure on the side cut-away, of a first example of a subsea unit for installation on the seabed. Subsea unit 1-A has an enclosure 1-1, and comprises an electric or electronic device 11, a two-phase cooling system 2 arranged to cool the electric or electronic device 11, a pressure compensating vessel 7, a valve 8-A, and a pressure relief-valve 12.

Examples of an electronic device are power electronic devices such as insulated gate bipolar transistors (IGBT) or integrated gate-commutated thyristors (IGCT) while examples of an electric device is a frequency converter or a transformer, which in the former case includes power electronic devices such as IGBTs.

The two-phase cooling system 2 comprises a conduit 3, an evaporator 4, a condenser 5 and cooling fluid 6-1. The conduit 3 forms a closed loop together with the evaporator 4 and the condenser 5 for circulating the cooling fluid 6-1 to thereby achieve cooling of the electric or electronic device 11.

According to one variation of the two-phase cooling system 2, the evaporator 4 has an inlet 4-1 and an outlet 4-2, and the condenser 5 has an inlet 5-1 and an outlet 5-2, wherein the conduit 3 connects the outlet 4-2 of the evaporator 4 with the inlet 5-1 of the condenser 5 and the outlet 5-2 of the condenser 5 with the inlet 4-1 of the evaporator 4. To that end, the conduit may either be a single piece conduit, or it may alternatively comprise several parts, e.g. a first part connecting the outlet of the evaporator to the inlet of the condenser and a second part connecting the outlet of the condenser to the inlet of the evaporator.

The two-phase cooling system 2 is preferably vertically oriented in the subsea unit 1-A when the subsea unit 1-A is installed on the seabed to thereby allow gravity-driven circulation of the cooling fluid 6-1. Thus, when the subsea unit 1-A is installed on the seabed, the section of the conduit 3 provided with the evaporator 4 provides a cooling fluid flow vertically upwards, and the section of the conduit 3 provided with the condenser 5 provides a cooling fluid flow vertically downwards in the direction of the seabed. According to one variation of the two-phase cooling system 1-1, the evaporator 4 and the condenser 5 are arranged in different horizontal planes when the subsea unit 1-A is arranged on the seabed. The evaporator 4 is arranged at a lower end of a first vertical portion of the conduit 3, through which the cooling fluid 6-1 is arranged to flow upwards, and the condenser 5 is arranged at an upper end of a second vertical portion of the conduit 3, through which the cooling fluid 6-1 is arranged to flow downwards, as shown in Figs 1a-b.

According to one variation of the subsea unit 1-A, the evaporator 4 is in thermal connection with the electronic or electric device 11 such that the heat emitted by the electronic or electric device 11 may be transmitted to the cooling fluid 6-1 for vaporisation thereof. According to one variation of the subsea unit 1-A, the condenser 5 is in thermal connection with an exterior of the enclosure 1-1 such that condensation of the cooling fluid 6-1 in vaporised state may be obtained. Optionally, fins may be provided on the external surface of the enclosure. As an alternative, the condenser could be provided outside the enclosure for direct seawater cooling of the condenser.

For the purpose of transmitting the ambient subsea pressure to the inside of the enclosure 1-1, the enclosure 1-1 has a portion that is mechanically flexible.

Furthermore, subsea unit 1-A comprises a liquid L for counteracting deformation of the enclosure 1-1 when the subsea unit 1-A is subject to an ambient subsea pressure higher than a pressure that the enclosure can withstand without deformation. Hereto, the liquid L fills the interior space of the subsea unit 1-A so as to prevent the occurrence of any air gaps between the inside surface of the enclosure 1-1 and any internal component of the subsea unit 1-A. The liquid L is advantageously a dielectric liquid such as oil in order to prevent short circuit of the electric or electronic device 11.

According to one variation of the two-phase cooling system 2, conduit 3 has a portion that is mechanically flexible so as to allow external pressure on the mechanically flexible portion of the conduit 3 to be transmitted to the interior of the conduit 3. Ambient pressure adaptation in the conduit 3 may thereby be obtained. Alternatively, the conduit, the evaporator and the condenser may have walls that are thick enough to withstand a pressure difference between a sealing pressure inside the conduit, the evaporator and the condenser and ambient pressure at a depth at which the subsea unit is to be installed. By sealing pressure is meant the pressure at which the cooling liquid is sealed in the two-phase cooling system when the two-phase cooling system is manufactured. According to this latter alternative, the pressure compensating vessel, the valve connecting the two-phase cooling system and the pressure compensating vessel, and the pressure-relief valve may be dispensed with as the pressure, i.e. the sealing pressure, in the two-phase cooling system is essentially constant at any ambient pressure which it has been constructed to withstand.

Preferably the cooling fluid 6-1 comprises at least two components which provide a thermodynamic two-phase state of the cooling fluid 6-1 at a pressure higher than the critical pressure of any of the individual components of the cooling fluid 6-1. In particular, the at least two components are selected so as to provide a thermodynamic two-phase state of the cooling liquid 6-1 also at ambient pressures at the depth at which the subsea unit 1-A is to be installed. More specifically, the at least two components are selected so as to provide a vapour-liquid two phase state also at ambient pressures at the depth at which the subsea unit 1-A is to be installed. The cooling fluid 6-1 may be a two-component mixture or a multi-component mixture comprising more than two components. The at least two components of the cooling fluid 6-1 may according to one variation be selected in such a way that they provide thermodynamic two-phase state of the cooling fluid also at atmospheric pressure. There exist a plurality of two-component and multi-component fluids suitable for the deep sea cooling purposes of this disclosure, for which ambient pressures on the seabed typically ranges from 100 to 400 bar.

When the subsea unit 1-A, and thus the conduit 3, is subjected to atmospheric pressure prior to installation on the seabed, the conduit 3 is advantageously only partially filled with cooling fluid 6-1. In order to be able to adapt the pressure in the conduit to ambient pressure, the pressure compensating vessel 7 comprises additional cooling fluid of the same kind as cooling fluid 6-1 in the conduit 3. The valve 8-A provides a fluid connection between the pressure compensating vessel 7 and the conduit 3 such that the additional cooling fluid may flow from the pressure compensating vessel 7 to the conduit 3 through the valve 8-A when the ambient pressure in the subsea unit 1-A becomes higher than the pressure inside the conduit 3. When manufacturing the subsea unit 1-A, the additional cooling fluid in the pressure compensating vessel is advantageously pressurised to seabed pressure of a depth at which the subsea unit is to be installed.

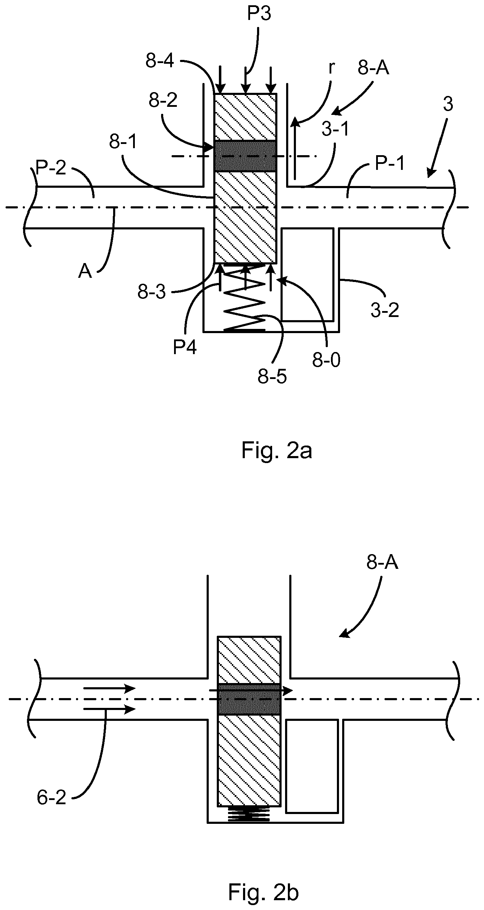

Fig. 2a is a cross-sectional side view of a portion 3-1 of the conduit 3 when connected to the valve 8 and the pressure compensating vessel 7. The valve 8-A, which is arranged in a valve case 8-0 at the interface between the conduit 3 and the pressure compensating vessel 7, has a body 8-1 having a through opening 8-2 in the axial direction A of the conduit portion 3-1 connected to the valve 8, a first end 8-3 and a second end 8-4 opposite the first end 8-3. The valve 8 further comprises a mechanical spring 8-5 arranged to apply a force in a radial direction r of the conduit portion 3-1 at the first end 8-3 of the valve 8.

The body 8-1 is movable in the valve case 8-0 in the radial direction r between a first position in which the body 8-1 blocks additional cooling fluid from flowing from the pressure compensating vessel 7 to the conduit 3, as shown in Fig. 2a, and a second position in which the through opening 8-2 is aligned with the interior of the conduit portion 3-1 to thereby allow additional cooling fluid 6-2, pressurised to a pressure P-2 corresponding to the pressure at which the subsea unit 1-A is to be installed, to flow from the pressure compensating vessel 7 to the conduit 3, as shown in Fig. 2b. The body 8-1 moves from the first position when there is a sufficient pressure difference between ambient pressure P-3 applied to the second end 8-4 of the body 8-1 and a pressure P4 applied to the first end 8-3 by the mechanical spring 8-5 and a pressure P-1 in the conduit 3. When the pressure P-1 in the conduit 3 has been adapted to ambient pressure P-3, the body 8-1 moves from the second position to the first position due to the force applied by the mechanical spring 8-5 on the first portion 8-3 of the body 8-1, thereby blocking further additional cooling fluid 6-2 from flowing from the pressure compensating vessel 7 to the conduit 3.

The pressure-relief valve 12 connects the conduit 3 and an exterior of the subsea unit 1-A. Similarly to a pressure cooker, the pressure-relief valve 12 is arranged to open when the ambient pressure in the subsea unit 1-A is lower than the pressure in the conduit to thereby let a portion of the cooling fluid 6-1 escape the subsea unit 1-A.

Fig. 1b shows a second example of a subsea unit. Subsea unit 1-B is similar to subsea unit 1-A of the first example, except for valve 8-B connecting the pressure compensating vessel 7 and the conduit 3, a control unit 9, a first pressure sensor 10-1 and a second pressure sensor 10-2. The first pressure sensor 10-1 is arranged to measure a pressure in the conduit 3 and the second pressure sensor 10-2 is arranged to measure the ambient pressure in the subsea unit 1-B, outside the conduit 3. The control unit 9 is connected to each of the sensors 10-1 and 10-2, and is arranged to provide a control signal to the valve 8-B to open when the ambient pressure outside the conduit measured by the second pressure sensor 10-2 is sufficiently higher than the pressure measured by the first pressure sensor 10-1. When the pressure inside the conduit 3 has been adapted to the ambient pressure, the control unit 9 is arranged to send a control signal to the valve 8-B to close.

It is envisaged that the subsea unit presented herein finds applications within the oil and gas industry, subsea HVDC/HVAC transmission and distribution systems as well as offshore power generation such as wind energy, tidal energy, wave energy, and ocean current energy.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A subsea unit (1-A; 1-B) arranged to house an electric or electronic device (11), wherein the subsea unit (1-A; 1-B) comprises a two-phase cooling system (2) arranged to cool the electric or electronic device (11), which two-phase cooling system (2) has an evaporator (4), a condenser (5), and a conduit (3) which together with the evaporator (4) and condenser (5) forms a closed loop for circulating a cooling fluid, wherein the evaporator (4) is arranged to be in thermal connection with the electric or electronic device (11), and wherein the subsea unit (1-A; 1-B) has an enclosure (1-1) arranged to enclose the two-phase cooling system (2), which enclosure (1-1) has a portion that is mechanically flexible such that an ambient subsea pressure can be transmitted to the inside of the enclosure, and wherein the subsea unit (1-A; 1-B) comprises a liquid (L) for counteracting deformation of the enclosure when subject to an ambient subsea pressure higher than a pressure that the enclosure can withstand, wherein the two-phase cooling system (2) comprises a cooling fluid (6-1) comprising at least two components that provide a thermodynamic two-phase state of the cooling fluid (6-1) at a pressure higher than the critical pressure of any of the individual components of the cooling fluid.

2. The subsea unit (1-A; 1-B) as claimed in claim 1, wherein the conduit (3) has a portion that is mechanically flexible so as to allow pressure inside the enclosure and outside the conduit to be transmitted to the inside of the conduit.

3. The subsea unit (1-A; 1-B) as claimed in claim 1 or 2, wherein the at least two components are adapted to provide a thermodynamic two-phase state of the cooling fluid (6-1) at ambient pressure at a depth at which the subsea unit (1-A; 1-B) is to be installed.

4. The subsea unit (1-A; 1-B) as claimed in any of the preceding claims, wherein the conduit (3) is partially filled with the cooling fluid (6-1) when the conduit (3) is subjected to sea level pressure, and wherein the subsea unit (1-A; 1-B) comprises a pressure compensating vessel (7) comprising additional cooling fluid (6-2), and a valve (8-A; 8-B), wherein the conduit (3) is arranged to be in fluid connection with the pressure compensation vessel (7) via the valve (8-A; 8-B) such that the additional cooling fluid (6-2) is able to flow from the pressure compensating vessel (7) to the conduit (3) when the subsea unit (1-A; 1-B) is subjected to a pressure that is higher than a pressure inside the conduit.

5. The subsea unit (1-A; 1-B) as claimed in claim 4, wherein the additional cooling fluid (6-2) in the pressure compensating vessel (7) is pressurised to seabed pressure of a depth at which the subsea unit (1-A; 1-B) is to be installed.

6. The subsea unit (1-A) as claimed in claim 4 or 5, wherein the valve (8-A) has a body (8-1) having a through opening (8-2) in the axial direction of a conduit portion (3-1) connected to the valve (8-A), which valve (8-A) is movable in a radial direction (r) of the conduit portion (3-1) between a first position in which the body (8-1) blocks the additional cooling fluid (6-2) from flowing from the pressure compensating vessel (7) to the conduit (3) and a second position in which the through opening (8-2) is aligned with the interior of the conduit portion (3-1) to thereby allow the additional cooling fluid (6-2) to flow from the pressure compensating vessel (7) to the conduit (3).

7. The subsea unit (1-A) as claimed in claim 6, wherein the valve (8-A) has a first end (8-3) in fluid communication with the cooling fluid (6-1) in the conduit and a second end (8-4), opposite the first end (8-3), subjected to ambient pressure, wherein a pressure difference between the first end (8-3) and the second end (8-4) allows the body (8-1) to move between the first position and the second position.

8. The subsea unit (1-A) as claimed in claim 7, comprising a mechanical spring (8-5) arranged to provide a force in the radial direction (r) at the first end (8-3) of the valve (8-A) so as to enable the body (8-1) to move from the second position to the first position.

9. The subsea unit (1-B) as claimed in any of claims 1-5, comprising a first pressure sensor (10-1) and a second pressure sensor (10-2) arranged to measure a pressure in the conduit (3) and outside the conduit in the subsea unit (1-B), respectively, and a control unit (9) arranged to control the valve (8-B) based on measurements of the first pressure sensor (10-1) and the second pressure sensor (10-2).

10. The subsea unit (1-A; 1-B) as claimed in any of the preceding claims, comprising a pressure-relief valve (12) connecting the conduit (3) and an exterior of the subsea unit (1-A; A-B), wherein the pressure-relief valve (12) is arranged to open when the ambient pressure in the subsea unit (1-A; 1-B) is lower than the pressure in the conduit (3) to thereby let a portion of the cooling fluid (6-1, 6-2) escape the subsea unit (1-A; 1-B).

11. The subsea unit (1-A; 1-B) as claimed in any of the preceding claims, wherein the condenser (5) is in thermal connection with an exterior of the enclosure (1-1).

12. The subsea unit as claimed in claim 1, wherein the two-phase cooling system comprises a cooling liquid, and wherein the conduit, the evaporator and the condenser have walls that are thick enough to withstand a pressure difference between a sealing pressure inside the conduit, the evaporator and the condenser, which sealing pressure is a pressure at which the cooling liquid has been sealed in the two-phase cooling system, and ambient pressure at a depth at which the subsea unit is to be installed.

13. A subsea power system comprising a subsea unit as claimed in any of claims 1-12.

14. The subsea power system as claimed in claim 13, wherein the subsea power system is a transmission system.

15. The subsea power system as claimed in claim 13, wherein the subsea power system is a distribution system.

## Patentansprüche

1. Unterwassereinheit (1-A; 1-B), die zur Unterbringung einer elektrischen oder elektronischen Vorrichtung (11) eingerichtet ist, wobei die Unterwassereinheit (1-A; 1-B) ein Zweiphasenkühlsystem (2) umfasst, das eingerichtet ist, um die elektrische oder elektronische Vorrichtung (11) zu kühlen, wobei das Zweiphasenkühlsystem (2) einen Verdampfer (4), einen Kondensator (5) und eine Rohrleitung (3) aufweist, die zusammen mit dem Verdampfer (4) und dem Kondensator (5) eine geschlossene Schleife zum Zirkulieren eines Kühlfluids bilden, wobei der Verdampfer (4) eingerichtet ist, um in thermischer Verbindung mit der elektrischen oder elektronischen Vorrichtung (11) zu sein, und wobei die Unterwassereinheit (1-A; 1-B) eine Umhausung (1-1) aufweist, die eingerichtet ist, um das Zweiphasenkühlsystem (2) zu umschließen, wobei die Umhausung (1-1) einen Anteil aufweist, der mechanisch flexibel ist, so dass ein Umgebungsunterwasserdruck an die Innenseite der Umhausung übertragen werden kann, und wobei die Unterwassereinheit (1-A; 1-B) eine Flüssigkeit (L) umfasst, um Verformung der Umhausung entgegenzuwirken, wenn diese Umgebungsunterwasserdruck ausgesetzt wird, der höher als ein Druck ist, den die Umhausung aushalten kann, wobei das Zweiphasenkühlsystem (2) ein Kühlfluid (6-1) umfasst, das mindestens zwei Komponenten umfasst, die einen thermodynamischen Zweiphasenzustand des Kühlfluids (6-1) bei einem Druck bereitstellen, der über dem kritischen Druck von jedweder der individuellen Komponenten des Kühlfluids liegt.

2. Unterwassereinheit (1-A; 1-B) nach Anspruch 1, wobei die Rohrleitung (3) einen Anteil aufweist, der mechanisch flexibel ist, um so zu ermöglichen, dass der Druck innerhalb der Umhausung und außerhalb der Rohrleitung auf das Innere der Rohrleitung übertragen wird.

3. Unterwassereinheit (1-A; 1-B) nach Anspruch 1 oder 2, wobei die mindestens zwei Komponenten angepasst sind, um bei Umgebungsdruck auf einer Tiefe, in der die Unterwassereinheit (1-A; 1-B) installiert werden soll, einen thermodynamischen Zweiphasenzustand des Kühlfluids (6-1) bereitzustellen.

4. Unterwassereinheit (1-A; 1-B) nach einem der vorhergehenden Ansprüche, wobei die Rohrleitung (3) teilweise mit dem Kühlfluid (6-1) gefüllt ist, wenn die Rohrleitung (3) Druck auf Meeresspiegel ausgesetzt ist, und wobei die Unterwassereinheit (1-A; 1-B) ein Druckausgleichgefäß (7), das zusätzliches Kühlfluid (6-2) umfasst, und ein Ventil (8-A; 8-B) umfasst, wobei die Rohrleitung (3) eingerichtet ist, um über das Ventil (8-A; 8-B) in Fluidverbindung mit dem Druckausgleichgefäß (7) zu sein, so dass das zusätzliche Kühlfluid (6-2) in der Lage ist, aus dem Druckausgleichgefäß (7) zu der Rohrleitung (3) zu fließen, wenn die Unterwassereinheit (1-A; 1-B) einem Druck ausgesetzt ist, der höher als ein Druck im Inneren der Rohrleitung ist.

5. Unterwassereinheit (1-A; 1-B) nach Anspruch 4, wobei das zusätzliche Kühlfluid (6-2) in dem Druckausgleichgefäß (7) auf Meeresgrunddruck in einer Tiefe unter Druck gesetzt wird, in der die Unterwassereinheit (1-A; 1-B) installiert werden soll.

6. Unterwassereinheit (1-A) nach Anspruch 4 oder 5, wobei das Ventil (8-A) einen Körper (8-1) mit einer Durchgangsöffnung (8-2) in der axialen Richtung eines Rohrleitungsanteils (3-1) aufweist, der mit dem Ventil (8-A) verbunden ist, wobei das Ventil (8-A) in einer Radialrichtung (r) des Rohrleitungsanteils (3-1) zwischen einer ersten Position, in der der Körper (8-1) das Fließen des zusätzlichen Kühlfluids (6-2) aus dem Druckausgleichgefäß (7) zu der Rohrleitung (3) blockiert, und einer zweiten Position beweglich ist, in der die Durchgangsöffnung (8-2) mit dem Inneren des Rohrleitungsanteils (3-1) ausgerichtet ist, um dadurch dem zusätzlichen Kühlfluid (6-2) das Fließen aus dem Druckausgleichgefäß (7) zu der Rohrleitung (3) zu gestatten.

7. Unterwassereinheit (1-A) nach Anspruch 6, wobei das Ventil (8-A) ein erstes Ende (8-3) in Fluidkommunikation mit dem Kühlfluid (6-1) in der Rohrleitung und ein zweites Ende (8-4) gegenüber von dem ersten Ende (8-3) aufweist, das Umgebungsdruck ausgesetzt ist, wobei eine Druckdifferenz zwischen dem ersten Ende (8-3) und dem zweiten Ende (8-4) es dem Körper (8-1) gestattet, sich zwischen der ersten Position und der zweiten Position zu bewegen.

8. Unterwassereinheit (1-A) nach Anspruch 7, umfassend eine mechanische Feder (8-5), die eingerichtet ist, um eine Kraft in der radialen Richtung (r) an dem ersten Ende (8-3) des Ventils (8-A) bereitzustellen, um so dem Körper (8-1) zu ermöglichen, sich von der zweiten Position zu der ersten Position zu bewegen.

9. Unterwassereinheit (1-B) nach einem der Ansprüche 1 bis 5, umfassend einen ersten Drucksensor (10-1) und einen zweiten Drucksensor (10-2), die eingerichtet sind, um einen Druck in der Rohrleitung (3) beziehungsweise außerhalb der Rohrleitung in der Unterwassereinheit (1-B) zu messen, und eine Steuereinheit (9), die eingerichtet ist, um das Ventil (8-B) basierend auf Messungen des ersten Drucksensors (10-1) und des zweiten Drucksensors (10-2) zu steuern.

10. Unterwassereinheit (1-A; 1-B) nach einem der vorhergehenden Ansprüche, umfassend ein Druckentlastungsventil (12), welches die Rohrleitung (3) und einen Außenbereich der Unterwassereinheit (1-A; 1-B) verbindet, wobei das Druckentlastungsventil (12) eingerichtet ist, um sich zu öffnen, wenn der Umgebungsdruck in der Unterwassereinheit (1-A; 1-B) niedriger als der Druck in der Rohrleitung (3) ist, um dadurch einen Teil des Kühlfluids (6-1, 6-2) aus der Unterwassereinheit (1-A; 1-B) entweichen zu lassen.

11. Unterwassereinheit (1-A; 1-B) nach einem der vorhergehenden Ansprüche, wobei der Kondensator (5) in thermischer Verbindung mit einem Außenbereich der Umhausung (1-1) ist.

12. Unterwassereinheit nach Anspruch 1, wobei das Zweiphasenkühlsystem eine Kühlflüssigkeit umfasst, und wobei die Rohrleitung, der Verdampfer und der Kondensator Wände aufweisen, die ausreichend dick sind, um eine Druckdifferenz zwischen einem Versiegelungsdruck innerhalb der Rohrleitung, des Verdampfers und des Kondensators, wobei der Versiegelungsdruck ein Druck ist, mit dem die Kühlflüssigkeit in dem Zweiphasenkühlsystem versiegelt worden ist, und dem Umgebungsdruck auf einer Tiefe, in der die Unterwassereinheit installiert werden soll, auszuhalten.

13. Unterwasser-Stromversorgungssystem, umfassend eine Unterwassereinheit nach einem der Ansprüche 1 bis 12.

14. Unterwasser-Stromversorgungssystem nach Anspruch 13, wobei das Unterwasser-Stromversorgungssystem ein Übertragungssystem ist.

15. Unterwasser-Stromversorgungssystem nach Anspruch 13, wobei das Unterwasser-Stromversorgungssystem ein Verteilungssystem ist.

## Revendications

1. Unité sous-marine (1-A ; 1-B) agencée pour abriter un dispositif électrique ou électronique (11), l'unité sous-marine (1-A ; 1-B) comprenant un système de refroidissement diphasique (2) agencé pour refroidir le dispositif électrique ou électronique (11), lequel système de refroidissement diphasique (2) a un évaporateur (4), un condenseur (5), et un conduit (3) qui, conjointement avec l'évaporateur (4) et le condenseur (5), forme une boucle fermée pour faire circuler un fluide de refroidissement, l'évaporateur (4) étant agencé pour être en connexion thermique avec le dispositif électrique ou électronique (11), et l'unité sous-marine (1-A ; 1-B) ayant une enceinte (1-1) agencée pour enfermer le système de refroidissement diphasique (2), laquelle enceinte (1-1) a une partie qui est mécaniquement flexible de telle sorte qu'une pression sous-marine ambiante peut être transmise à l'intérieur de l'enceinte, et l'unité sous-marine (1-A ; 1-B) comprenant un liquide (L) destiné à contrebalancer une déformation de l'enceinte lorsqu'elle est soumise à une pression sous-marine ambiante supérieure à une pression que l'enceinte peut supporter, le système de refroidissement diphasique (2) comprenant un fluide de refroidissement (6-1) comprenant au moins deux constituants qui fournissent un état thermodynamique diphasique du fluide de refroidissement (6-1) à une pression supérieure à la pression critique de n'importe quel constituant individuel du fluide de refroidissement.

2. Unité sous-marine (1-A ; 1-B) selon la revendication 1, dans laquelle le conduit (3) a une partie qui est mécaniquement flexible de manière à permettre à la pression à l'intérieur de l'enceinte et à l'extérieur du conduit d'être transmise à l'intérieur du conduit.

3. Unité sous-marine (1-A ; 1-B) selon la revendication 1 ou 2, dans laquelle les au moins deux constituants sont adaptés pour fournir un état thermodynamique diphasique du fluide de refroidissement (6-1) à pression ambiante à une profondeur à laquelle l'unité sous-marine (1-A ; 1-B) doit être installée.

4. Unité sous-marine (1-A ; 1-B) selon l'une quelconque des revendications précédentes, le conduit (3) étant partiellement rempli avec le fluide de refroidissement (6-1) quand le conduit (3) est soumis à la pression au niveau de la mer, et l'unité sous-marine (1-A ; 1-B) comprenant une cuve de compensation de pression (7) comprenant un fluide de refroidissement supplémentaire (6-2), et une vanne (8-A ; 8-B), le conduit (3) étant agencé pour être en connexion fluidique avec la cuve de compensation de pression (7) par le biais de la vanne (8-A ; 8-B) de telle sorte que le fluide de refroidissement supplémentaire (6-2) peut circuler de la cuve de compensation de pression (7) au conduit (3) quand l'unité sous-marine (1-A ; 1-B) est soumise à une pression qui est supérieure à une pression à l'intérieur du conduit.

5. Unité sous-marine (1-A ; 1-B) selon la revendication 4, dans laquelle le fluide de refroidissement supplémentaire (6-2) dans la cuve de compensation de pression (7) est pressurisé à la pression sur les fonds marins d'une profondeur à laquelle l'unité sous-marine (1-A ; 1-B) doit être installé.

6. Unité sous-marine (1-A) selon la revendication 4 ou 5, dans laquelle la vanne (8-A) a un corps (8-1) ayant une ouverture traversante (8-2) dans la direction axiale d'une partie de conduit (3-1) raccordée à la vanne (8-A), laquelle vanne (8-A) est mobile dans une direction radiale (r) de la partie de conduit (3-1) entre une première position dans laquelle le corps (8-1) empêche le fluide de refroidissement supplémentaire (6-2) de circuler de la cuve de compensation de pression (7) au conduit (3) et une deuxième position dans laquelle l'ouverture traversante (8-2) est alignée avec l'intérieur de la partie de conduit (3-1) pour permettre ainsi au fluide de refroidissement supplémentaire (6-2) de circuler de la cuve de compensation de pression (7) au conduit (3).

7. Unité sous-marine (1-A) selon la revendication 6, dans laquelle la vanne (8-A) a une première extrémité (8-3) en communication fluidique avec le fluide de refroidissement (6-1) dans le conduit et une deuxième extrémité (8-4), à l'opposé de la première extrémité (8-3), soumise à la pression ambiante, une différence de pression entre la première extrémité (8-3) et la deuxième extrémité (8-4) permettant au corps (8-1) de se déplacer entre la première position et la deuxième position.

8. Unité sous-marine (1-A) selon la revendication 7, comprenant un ressort mécanique (8-5) agencé pour appliquer une force dans la direction radiale (r) à la première extrémité (8-3) de la vanne (8-A) de manière à permettre au corps (8-1) de se déplacer de la deuxième position à la première position.

9. Unité sous-marine (1-B) selon l'une quelconque des revendications 1 à 5, comprenant un premier capteur de pression (10-1) et un deuxième capteur de pression (10-2) agencés pour mesurer une pression dans le conduit (3) et à l'extérieur du conduit dans l'unité sous-marine (1-B), respectivement, et une unité de commande (9) agencée pour commander la vanne (8-B) en se basant sur des mesures du premier capteur de pression (10-1) et du deuxième capteur de pression (10-2).

10. Unité sous-marine (1-A ; 1-B) selon l'une quelconque des revendications précédentes, comprenant une soupape de décharge (12) raccordant le conduit (3) et un extérieur de l'unité sous-marine (1-A ; 1-B), la soupape de décharge (12) étant agencée pour s'ouvrir quand la pression ambiante dans l'unité sous-marine (1-A ; 1-B) est inférieure à la pression dans le conduit (3) pour laisser ainsi une partie du fluide de refroidissement (6-1, 6-2) s'échapper de l'unité sous-marine (1-A ; 1-B).

11. Unité sous-marine (1-A ; 1-B) selon l'une quelconque des revendications précédentes, dans laquelle le condenseur (5) est en connexion thermique avec un extérieur de l'enceinte (1-1).

12. Unité sous-marine selon la revendication 1, dans laquelle le système de refroidissement diphasique comprend un liquide de refroidissement, et dans laquelle le conduit, l'évaporateur le condenseur ont des parois qui sont suffisamment épaisses pour supporter une différence de pression entre une pression d'étanchéité à l'intérieur du conduit, de l'évaporateur et du condensateur, laquelle pression d'étanchéité est une pression à laquelle le liquide de refroidissement a été scellé dans le système de refroidissement diphasique, et la pression ambiante à une profondeur à laquelle l'unité sous-marine doit être installée.

13. Système électrique sous-marin comprenant une unité sous-marine selon l'une quelconque des revendications 1 à 12.

14. Système électrique sous-marin selon la revendication 13, le système électrique sous-marin étant un système de transmission.

15. Système électrique sous-marin selon la revendication 13, le système électrique sous-marin étant un système de distribution.
